(19) **Europäisches Patentamt / European Patent Office / Office européen des brevets**

(11) **EP 2 884 288 B1**

(12) **FASCICULE DE BREVET EUROPEEN**

(45) Date de publication et mention
de la délivrance du brevet:
**21.09.2016 Bulletin 2016/38**

(51) Int Cl.:
***G01R 15/18*** *(2006.01)*   ***G01R 19/20*** *(2006.01)*
***H02M 3/335*** *(2006.01)*

(21) Numéro de dépôt: **14307036.5**

(22) Date de dépôt: **15.12.2014**

(54) **Dispositif de mesure d'un courant haché**

Messvorrichtung zur Messung eines zerhackten Stroms

Device for measuring a chopped current

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.12.2013 FR 1362667**

(43) Date de publication de la demande:
**17.06.2015 Bulletin 2015/25**

(60) Demande divisionnaire:
**15198460.6 / 3 015 870**

(73) Titulaire: **Valeo Systèmes de Contrôle Moteur
95800 Cergy (FR)**

(72) Inventeurs:
• **Sardat, Pierre**
 **93340 Le Raincy (FR)**
• **Moreau, Maxime**
 **95320 Saint- Leu- La Foret (FR)**

(56) Documents cités:
**EP-A2- 0 631 145      WO-A1-03/028198
GB-A- 2 143 998      US-A- 5 068 776
US-A- 5 610 508      US-A- 5 815 391
US-A1- 2011 316 524   US-A1- 2012 127 769**

## Description

La présente invention concerne un dispositif de mesure d'un courant haché.

Un tel dispositif de mesure s'applique en particulier à la mesure d'un courant haché circulant à l'entrée d'un convertisseur de courant continu en courant continu.

Un tel dispositif de mesure peut comporter un transformateur d'impulsions. Le transformateur comporte un circuit primaire dans lequel circule le courant haché, et un circuit secondaire dans lequel circule un courant de sortie proportionnel au courant haché. Le circuit secondaire du transformateur comprend deux bornes de sortie entre lesquelles est connecté un circuit de mesure du courant de sortie. Le circuit de mesure comprend généralement une résistance.

Il arrive que l'on ait besoin de mesurer un courant haché à valeur moyenne non nulle, par exemple pour mesurer le courant haché circulant dans un convertisseur de courant continu en courant continu, reliant deux batteries d'alimentation de tensions différentes.

Par conséquent, il est nécessaire de démagnétiser régulièrement le transformateur d'impulsions. En effet, en première approximation, on peut modéliser les imperfections du transformateur d'impulsions par une inductance magnétisante disposée entre les bornes de sortie du circuit secondaire. Le dispositif de mesure comporte à cet effet des moyens de démagnétisation du transformateur. À titre d'exemple, la démagnétisation s'opère en faisant par exemple circuler le courant magnétisant à travers un circuit de démagnétisation de sorte que l'énergie accumulée dans l'inductance magnétisante puisse être ainsi libérée.

Le courant à mesurer peut comporter aussi des valeurs instantanées positives, négatives ou nulles. À cet effet, selon une solution connue, le circuit de mesure comporte un interrupteur et des moyens de synchronisation de cet interrupteur avec le courant haché, pour permettre au courant de sortie de circuler dans le circuit de mesure lorsque le courant haché est non nul (positif ou négatif) et pour empêcher toute circulation de courant dans le circuit de mesure lorsque le courant haché est nul.

L'interrupteur permet la circulation du courant de sortie dans les deux sens dans le circuit de mesure.

Le circuit de démagnétisation comprend généralement une diode Zener montée en série avec une diode disposée en sens inverse de la diode Zener.

L'opération de démagnétisation est effectuée pendant les périodes dites de roue libre lorsque le courant haché est nul.

La phase de démagnétisation est donc tributaire de la période de roue libre. Cependant, cette période dépend du rapport cyclique et peut ne pas être suffisamment longue pour permettre la démagnétisation du transformateur.

Le document US2012/127769A1 décrit un dispositif de mesure d'un courant haché apte à circuler dans un circuit présentant une structure de pont en H comprenant une première branche et une deuxième branche.

Le document WO03/028198A1 décrit un dispositif de mesure d'un courant haché apte à circuler dans une branche d'un circuit.

L'invention a pour objectif de pallier au moins partiellement ces inconvénients de l'art antérieur, en proposant un dispositif de mesure d'un courant haché, capable de mesurer un courant bidirectionnel, tout en garantissant un temps suffisant pour permettre une démagnétisation.

À cet effet, l'invention a pour objet un dispositif de mesure d'un courant haché apte à circuler dans un circuit présentant une structure de pont en H comprenant une première branche et une deuxième branche, caractérisé en ce qu'il comporte :

- deux transformateurs respectivement connectés à une branche du pont en H, les transformateurs comportant respectivement un circuit primaire configuré pour la circulation d'un courant haché, et un circuit secondaire,
- deux circuits de démagnétisation des deux transformateurs, et
- deux circuits de mesure respectivement connectés aux bornes du circuit secondaire d'un transformateur associé, les circuits de mesure comprenant respectivement au moins une unité qui comporte un premier commutateur et un deuxième commutateur connectés en inverse, les deux commutateurs étant respectivement réalisés par un transistor et étant aptes à être pilotés de façon :

  - à autoriser la circulation du courant induit par le courant haché, dans le circuit de mesure lorsque le circuit primaire d'un transformateur associé est fermé et
  - à empêcher la circulation du courant de démagnétisation dans le circuit de mesure lorsque le circuit primaire d'un transformateur associé est ouvert ;

les circuits de mesure comprenant une résistance de mesure commune connectée par une première borne à la masse, et par une deuxième borne à la source du premier transistor du premier circuit de mesure et à la source du premier transistor du deuxième circuit de mesure.

Ainsi, la présence d'un transformateur dans chaque branche du pont en H permet de toujours avoir la moitié d'une période de fonctionnement pour la démagnétisation du transformateur. On connaît le temps de démagnétisation qui devient constant et n'est plus tributaire du rapport cyclique.

Selon un mode de réalisation, le premier commutateur et le deuxième commutateur sont respectivement réalisés par un transistor à effet de champ.

Selon un exemple :

- le premier commutateur d'un circuit de mesure comporte une borne connectée à une deuxième borne de la résistance de mesure, la première borne de la résistance de mesure étant connectée à la masse ; et
- le deuxième commutateur d'un circuit de mesure comporte une borne connectée à la masse.

Selon un autre aspect de l'invention :

- les branches du circuit comprennent respectivement un premier commutateur et un deuxième commutateur,
- le premier transformateur est connecté au premier commutateur de la première branche et le deuxième transformateur est connecté au premier commutateur de la deuxième branche, et
- l'unité du premier circuit de mesure configurée pour autoriser ou empêcher la circulation d'un courant induit par le courant haché dans le premier circuit de mesure est configurée pour être pilotée par l'inverse du signal de commande du deuxième commutateur de la première branche et
- l'unité du deuxième circuit de mesure configurée pour autoriser ou empêcher la circulation d'un courant induit par le courant haché dans le deuxième circuit de mesure est configurée pour être pilotée par l'inverse du signal de commande du deuxième commutateur de la deuxième branche.

Selon un exemple de réalisation :

- le premier circuit de mesure comporte une première résistance et une deuxième résistance, la borne commune aux deux résistances étant connectée à la grille du premier transistor et du deuxième transistor du premier circuit de mesure, et
- le deuxième circuit de mesure comporte une première résistance et une deuxième résistance, la borne commune aux deux résistances étant connectée à la grille du premier transistor et du deuxième transistor du deuxième circuit de mesure.

Selon un autre aspect de l'invention, les moyens de démagnétisation comportent respectivement un circuit de démagnétisation connecté entre les deux bornes de sortie du circuit secondaire du transformateur associé.

Un circuit de démagnétisation comporte par exemple deux diodes Zener montées en série et en sens inverse.

D'autres caractéristiques et avantages de l'invention apparaîtront plus clairement à la lecture de la description suivante, donnée à titre d'exemple illustratif et non limitatif, et des dessins annexés parmi lesquels :

- la figure 1 représente un circuit de convertisseur de courant continu en courant continu dans lequel circule un courant haché comprenant deux transformateurs d'un dispositif de mesure du courant haché,

- la figure 2 représente schématiquement deux circuits de démagnétisation et deux circuits de mesure du dispositif de mesure du courant haché selon un premier mode de réalisation,
- la figure 3 représente schématiquement deux circuits de démagnétisation et deux circuits de mesure du dispositif de mesure du courant haché dans un dispositif ne faisant pas partie de l'invention,
- la figure 4 est une représentation plus détaillée des circuits de démagnétisation et des circuits de mesure du dispositif de mesure du courant haché de la figure 2 selon le premier mode de réalisation,
- la figure 5 est un graphe représentant l'évolution temporelle de courants hachés dans les circuits primaires de deux transformateurs respectivement connectés à une branche du convertisseur de structure en pont en H,
- la figure 6 est un premier exemple de chronogramme représentant l'évolution temporelle des courants hachés de la figure 5, et les signaux d'impulsions des commutateurs des branches du pont en H,
- la figure 7 est un deuxième exemple de chronogramme représentant l'évolution temporelle de courants hachés dans les circuits primaires de deux transformateurs respectivement connecté à une branche du convertisseur de structure en pont en H, et les signaux d'impulsions des commutateurs des branches du pont en H, et
- la figure 8 représente de façon schématique un exemple de comparateurs utilisés après la mesure d'une tension de sortie proportionnelle au courant haché d'entrée.

Sur ces figures, les éléments identiques portent les mêmes références.

L'invention concerne un dispositif 1 de mesure d'un courant haché, en particulier circulant à l'intérieur d'un convertisseur 3 de courant continu en courant continu.

Convertisseur

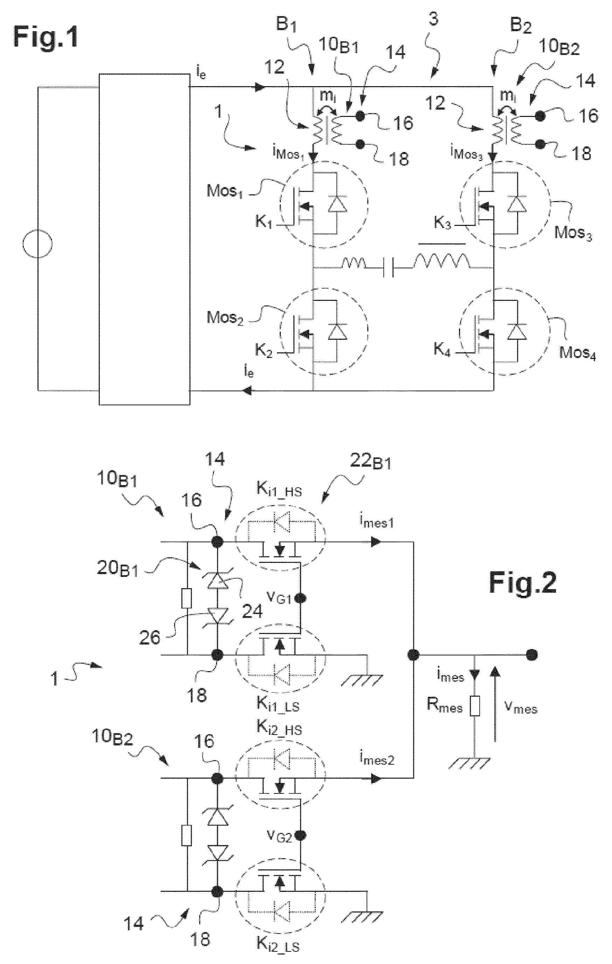

En référence à la figure 1, le convertisseur 3 représenté présente une structure de pont en H présentant une première branche $B_1$ et une seconde branche $B_2$.

La première branche $B_1$ comporte un premier commutateur $Mos_1$ et un deuxième commutateur $Mos_2$.

La seconde branche $B_2$ comporte un premier commutateur $Mos_3$ et un deuxième commutateur $Mos_4$.

Les commutateurs $Mos_1$ à $Mos_4$ comportent à titre d'exemple non limitatif un transistor à effet de champ connu sous l'acronyme MOSFET, de type N.

Lorsque la première branche $B_1$ est commandée, le premier commutateur $Mos_1$ est passant lorsque

le deuxième commutateur $Mos_2$ est bloqué, et réciproquement le deuxième commutateur $Mos_2$ est passant lorsque le premier commutateur $Mos_1$ est bloqué.

Il en va de même pour la commande de la seconde branche $B_2$, le premier commutateur $Mos_3$ est passant lorsque le deuxième commutateur $Mos_4$ est bloqué, et réciproquement le deuxième commutateur $Mos_4$ est passant lorsque le premier commutateur $Mos_3$ est bloqué.

Le décalage entre les deux branches $B_1$ et $B_2$ dépend de la logique de commande du pont en H.

**Dispositif de mesure du courant haché**

En se référant de nouveau à la figure 1, le dispositif 1 de mesure du courant haché comporte deux transformateurs $10_{B1}$ et $10_{B2}$ de rapport de transformation $m_i$. Les deux transformateurs $10_{B1}$ et $10_{B2}$ sont respectivement agencés au niveau d'une branche $B_1$ ou $B_2$ du convertisseur 3.

Un transformateur $10_{B1}$ ou $10_{B2}$ comprend un circuit primaire 12 et un circuit secondaire 14.

Le circuit primaire 12 d'un premier transformateur $10_{B1}$ est connecté au premier commutateur $Mos_1$ de la première branche $B_1$ du convertisseur 3. Le circuit primaire 12 du deuxième transformateur $10_{B2}$ est connecté au premier commutateur $Mos_3$ de la deuxième branche $B_2$ du convertisseur 3.

Le circuit secondaire 14 d'un transformateur $10_{B1}$ ou $10_{B2}$ comporte deux bornes de sortie 16 et 18.

Lorsqu'un courant haché $i_e$ circule dans le convertisseur 3, il se divise au niveau des deux branches $B_1$ et $B_2$, de sorte qu'un premier courant haché $i_{Mos1}$ circule dans le circuit primaire 12 du premier transformateur $10_{B1}$, et qu'un deuxième courant haché $i_{Mos3}$ circule dans le circuit primaire 12 du deuxième transformateur $10_{B2}$.

Lorsque le circuit primaire 12 du premier transformateur $10_{B1}$ ou du deuxième transformateur $10_{B2}$ est fermé, le courant haché $i_{Mos1}$ ou $i_{Mos3}$ circulant dans le circuit primaire 12 du premier transformateur $10_{B1}$ ou du deuxième transformateur $10_{B2}$ est non nul, et le transformateur $10_{B1}$ ou $10_{B2}$ associé est magnétisé.

Une démagnétisation d'un transformateur $10_{B1}$ ou $10_{B2}$ s'effectue lorsque le circuit primaire 12 du premier transformateur $10_{B1}$ ou du deuxième transformateur $10_{B2}$ est ouvert, le courant haché $i_{Mos1}$ ou $i_{Mos3}$ étant nul, c'est-à-dire lorsqu'il n'y a pas de courant à mesurer.

Et en outre, le dispositif 1 de mesure permet de mesurer le courant haché lorsque le circuit primaire 12 du premier transformateur $10_{B1}$ ou du deuxième transformateur $10_{B2}$ est fermé, le courant haché $i_{Mos1}$ ou $i_{Mos3}$ circulant dans le circuit primaire 12 du premier transformateur $10_{B1}$ ou du deuxième transformateur $10_{B2}$ étant non nul.

À cet effet, en référence à la figure 2, le dispositif 1 de mesure comprend en outre :

- deux circuits de démagnétisation $20_{B1}$, $20_{B2}$ respectivement associés à un transformateur $10_{B1}$ ou $10_{B2}$, et

- deux circuits de mesure $22_{B1}$ et $22_{B2}$ du courant haché respectivement connectés aux bornes de sortie 16, 18 du transformateur $10_{B1}$ ou $10_{B2}$ associé.

Selon le mode de réalisation décrit, les circuits de démagnétisation $20_{B1}$, $20_{B2}$ sont distincts des circuits de mesure $22_{B1}$ et $22_{B2}$.

Chaque circuit de démagnétisation $20_{B1}$, $20_{B2}$ est branché entre les deux bornes de sortie 16 et 18 du transformateur $10_{B1}$ ou $10_{B2}$ associé.

Chaque circuit de démagnétisation $20_{B1}$, $20_{B2}$ permet la démagnétisation du transformateur associé $10_{B1}$ ou $10_{B2}$ par une circulation d'un courant dans le circuit de démagnétisation $20_{B1}$ ou $20_{B2}$.

Selon le mode de réalisation illustré sur la figure 2, un circuit de démagnétisation $20_{B1}$ ou $20_{B2}$ comprend une première diode Zener 24 connectée en série avec une seconde diode Zener 26 entre les bornes de sortie 16 et 18. La tension Zener est à titre d'exemple illustratif de l'ordre de 10V.

La première diode Zener 24 et la seconde diode Zener 26 sont montées en sens inverse. À titre d'exemple, la première diode Zener 24 peut être connectée par sa cathode à la borne de sortie 16 et la deuxième diode Zener 26 peut être connectée par sa cathode à l'autre borne de sortie 18. Les deux diodes Zener 24 et 26 sont alors connectées l'une avec l'autre par leurs anodes.

Ainsi, les circuits de démagnétisation $20_{B1}$, $20_{B2}$ sont bidirectionnels, c'est-à-dire qu'ils permettent une démagnétisation dans les deux sens de circulation du courant magnétisant, selon si la valeur moyenne du courant haché est positive ou négative.

Un premier circuit de mesure $22_{B1}$ est connecté aux bornes de sortie 16, 18 du circuit secondaire 14 du premier transformateur $10_{B1}$ connecté à la première branche $B_1$ du convertisseur 3. Le premier circuit de mesure $22_{B1}$ est connecté en parallèle du premier circuit de démagnétisation $20_{B1}$.

Un deuxième circuit de mesure $22_{B2}$ est connecté aux bornes de sortie 16, 18 du circuit secondaire 14 du deuxième transformateur $10_{B2}$ connecté à la deuxième branche $B_2$ du convertisseur 3. Le deuxième circuit de mesure $22_{B2}$ est connecté en parallèle du deuxième circuit de démagnétisation $20_{B2}$ Le deuxième circuit de mesure $22_{B2}$ est en outre connecté au premier circuit de mesure $22_{B1}$.

Les circuits de mesure $22_{B1}$ et $22_{B2}$ comprennent respectivement au moins une unité configurée pour :

- autoriser la circulation d'un courant $i_{mes1}$ ; $i_{mes2}$ induit par le courant haché, dans le circuit de mesure $22_{B1}$ ou $22_{B2}$, lorsque le circuit primaire 12 d'un transformateur $10_{B1}$ ; $10_{B2}$ est fermé ; dans ce cas le courant haché circulant dans le circuit primaire 12 est non nul, soit strictement positif ou strictement négatif, et

- empêcher la circulation du courant de démagnétisation dans le circuit de mesure $22_{B1}$ ou $22_{B2}$ lorsque le circuit primaire 12 d'un transformateur $10_{B1}$ ; $10_{B2}$ est ouvert, dans ce cas le courant haché circulant dans le circuit primaire 12 est nul.

Selon le mode de réalisation décrit, les deux circuits de mesure $22_{B1}$ et $22_{B2}$ comprennent respectivement une unité configurée pour autoriser ou empêcher la circulation d'un courant induit par le courant haché dans le circuit de mesure $22_{B1}$ ou $22_{B2}$ associé, et comportant un premier commutateur et un deuxième commutateur. L'unité du premier circuit de mesure $22_{B1}$ comprend un premier commutateur $K_{i1\_HS}$ et un deuxième commutateur $K_{i1\_LS}$. L'unité du deuxième circuit de mesure $22_{B2}$ comprend un premier commutateur $K_{i2\_HS}$ et un deuxième commutateur $K_{i2\_LS}$.

Les premiers commutateurs $K_{i1\_HS}$ et $K_{i2\_HS}$ sont également appelés commutateurs côté haut ou « High Side » en anglais.

Les deuxièmes commutateurs $K_{i1\_LS}$ et $K_{i2\_LS}$ sont également appelés commutateurs côté bas ou « Low Side » en anglais.

Le premier et le deuxième commutateurs $K_{i1\_HS}$ et $K_{i1\_LS}$ du premier circuit de mesure $22_{B1}$ et les premier et deuxième commutateurs $K_{i2\_HS}$ et $K_{i2\_LS}$ du deuxième circuit de mesure $22_{B2}$ sont formés selon l'exemple décrit par des transistors à effet de champ, de type MOSFET.

Le premier et le deuxième commutateurs $K_{i1\_HS}$ et $K_{i1\_LS}$ du premier circuit de mesure $22_{B1}$ sont dans cet exemple connectés en inverse. De même, les premier et deuxième commutateurs $K_{i2\_HS}$ et $K_{i2\_LS}$ du deuxième circuit de mesure $22_{B2}$ sont connectés en inverse.

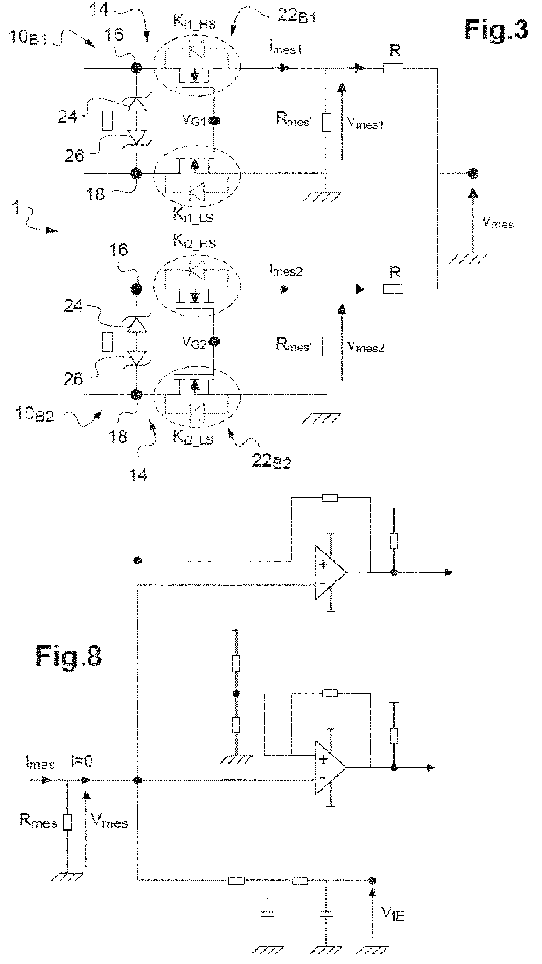

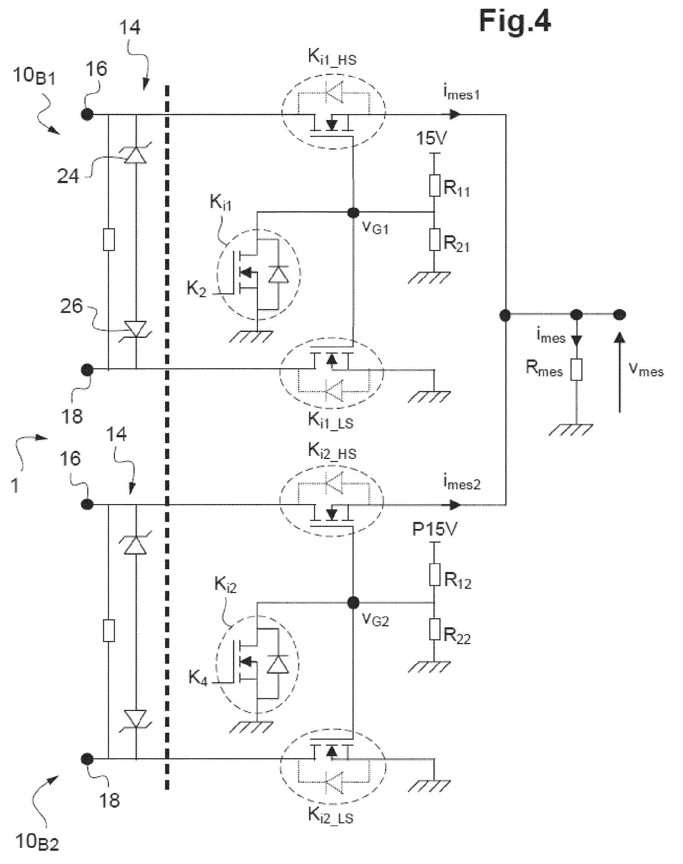

En outre, en référence aux figures 3 et 4, les circuits de mesure $22_{B1}$ ; $22_{B2}$ comprennent au moins une résistance de mesure $R_{mes}$ ou $R_{mes}$ connectée par une première borne à la masse.

Le premier commutateur $K_{i1\_HS}$ ; $K_{i2\_HS}$ d'un circuit de mesure $22_{B1}$ ; $22_{B2}$ comporte une borne connectée à une deuxième borne de la résistance de mesure $R_{mes}$ ou $R_{mes}$, la première borne de la résistance de mesure $R_{mes}$ ou $R_{mes}$ étant connectée à la masse. Le deuxième commutateur $K_{i1\_LS}$ ; $K_{i2\_LS}$ d'un circuit de mesure $22_{B1}$ ; $22_{B2}$ comporte quant à lui une borne connectée à la masse.

Plus précisément, en ce qui concerne le premier circuit de mesure $22_{B1}$ :

- le drain du premier transistor $K_{i1\_HS}$ est connecté à la première borne de sortie 16 du premier transformateur $10_{B1}$ connecté à la première branche $B_1$ du convertisseur 3,
- la source du premier transistor $K_{i1\_HS}$ est connectée par une borne à la deuxième borne de la résistance de mesure $R_{mes}$ (figure 2) ou $R_{mes}$ (figure 3), la première borne de la résistance de mesure $R_{mes}$ (figure 2) ou $R_{mes}$ (figure 3), étant connectée à la masse, et

- la grille du premier transistor $K_{i1\_HS}$ est connectée à la grille du deuxième transistor $K_{i1\_LS}$ du premier circuit de mesure $22_{B1}$,
- le drain du deuxième transistor $K_{i1\_LS}$ est connecté à la deuxième borne de sortie 18 du premier transformateur $10_{B1}$, et
- la source du deuxième transistor $K_{i1\_LS}$ est connectée à la masse.

Concernant le deuxième circuit de mesure $22_{B2}$ :

- le drain du premier transistor $K_{i2\_HS}$ est connecté à la première borne de sortie 16 du deuxième transformateur $10_{B2}$ connecté à la deuxième branche $B_2$ du convertisseur 3,
- la source du premier transistor $K_{i2\_HS}$ est connectée par une borne à la deuxième borne de la résistance de mesure $R_{mes}$ (figure 2) ou $R_{mes}$ (figure 3), la première borne de la résistance de mesure $R_{mes}$ (figure 2) ou $R_{mes}$ (figure 3), étant connectée à la masse, et
- la grille du premier transistor $K_{i2\_HS}$ est connectée à la grille du deuxième transistor $K_{i2\_LS}$ du deuxième circuit de mesure $22_{B2}$,
- le drain du deuxième transistor $K_{i2\_LS}$ du deuxième circuit de mesure $22_{B2}$ est connecté à la deuxième borne de sortie 18 du deuxième transformateur $10_{B2}$,
- la source du deuxième transistor $K_{i2\_LS}$ est connectée à la masse.

De plus, les premiers transistors $K_{i1\_HS}$ et $K_{i2\_HS}$ doivent être tels que la tension entre la grille et la source est supérieure à la tension de seuil du transistor pour activer le transistor.

Les transistors $K_{i1\_HS}$ et $K_{i1\_LS}$ du premier circuit de mesure $22_{B1}$ et les transistors $K_{i2\_HS}$ et $K_{i2\_LS}$ du deuxième circuit de mesure $22_{B2}$ sont aptes à être commandés en fonction de la logique de commande du pont en H. Ainsi, lorsque le circuit primaire 12 d'un transformateur $10_{B1}$ ou $10_{B2}$ est fermé, le courant haché au circuit primaire 12 du transformateur $10_{B1}$ ou $10_{B2}$ est non nul, et les deux transistors $K_{i1\_HS}$ et $K_{i1\_LS}$ ou $K_{i2\_HS}$ et $K_{i2\_LS}$ du circuit de mesure $22_{B1}$ ou $22_{B2}$ associé sont à l'état passant. Lorsque le circuit primaire 12 du premier transformateur $10_{B1}$ ou du deuxième transformateur $10_{B2}$ est ouvert, le courant haché est nul, et les deux transistors $K_{i1-HS}$ et $K_{i1\_LS}$ ou $K_{i2\_HS}$ et $K_{i2\_LS}$ du circuit de mesure $22_{B1}$ ou $22_{B2}$ associé sont à l'état bloqué.

Ainsi, lorsque le circuit primaire 12 d'un transformateur $10_{B1}$ ou $10_{B2}$ est fermé, le courant haché $i_{Mos1}$ ou $i_{Mos3}$ au circuit primaire 12 d'un transformateur $10_{B1}$ ou $10_{B2}$ étant non nul, et qu'il y a donc un courant à mesurer, les deux transistors $K_{i1\_HS}$ et $K_{i1\_LS}$ ou $K_{i2\_HS}$ et $K_{i2\_LS}$ du circuit de mesure $22_{B1}$ ou $22_{B2}$ associé doivent être commandés à l'état passant.

Et, la démagnétisation d'un transformateur $10_{B1}$ ou $10_{B2}$ peut être réalisée lorsque le circuit primaire 12 du transformateur $10_{B1}$ ou $10_{B2}$ est ouvert, le courant haché $i_{Mos1}$ ou $i_{Mos3}$ étant nul et il n'y a pas de courant à mesurer, en bloquant les deux transistors $K_{i1\_HS}$ et $K_{i1\_LS}$ ou $K_{i2\_HS}$ et $K_{i2\_LS}$ du circuit de mesure $22_{B1}$ ou $22_{B2}$ associé, de façon à déconnecter le circuit de démagnétisation $20_{B1}$ ou $20_{B2}$ de la résistance de mesure Rmes ou Rmes' pendant la démagnétisation du transformateur $10_{B1}$ ou $10_{B2}$ correspondant.

Lorsque le circuit primaire 12 du premier transformateur $10_{B1}$ ou du deuxième transformateur $10_{B2}$ est fermé, un courant haché $i_{Mos1}$ ou $i_{Mos3}$ circule dans le circuit primaire 12 du transformateur associé $10_{B1}$ ou $10_{B2}$, et un courant est induit dans le circuit secondaire 14 du transformateur associé $10_{B1}$ ou $10_{B2}$. Si les transistors $K_{i1\_HS}$ et $K_{i1\_LS}$ du premier circuit de mesure $22_{B1}$, respectivement si les transistors $K_{i2\_HS}$ et $K_{i2\_LS}$ du deuxième circuit de mesure $22_{B2}$, sont passants, un courant $i_{mes1}$, respectivement $i_{mes2}$, circule dans le premier ou deuxième circuit de mesure associé $22_{B1}$ ou $22_{B2}$.

Selon un premier mode de réalisation illustré sur la figure 2, les deux circuits de mesure $22_{B1}$ et $22_{B2}$ comportent en outre une résistance de mesure $R_{mes}$ commune connectée d'une part par une première borne à la masse et par une deuxième borne à la source des deux premiers transistors $K_{i1\_HS}$ et $K_{i2\_HS}$. La source du premier transistor $K_{i1-HS}$ de l'unité apte à autoriser ou empêcher la circulation d'un courant induit par le courant haché dans le premier circuit de mesure $22_{B1}$, est donc connectée à la source du premier transistor $K_{i2\_HS}$ de l'unité apte à autoriser ou empêcher la circulation d'un courant induit par le courant haché dans le deuxième circuit de mesure $22_{B2}$.

Ainsi, les courants $i_{mes1}$ et $i_{mes2}$ circulant respectivement dans le premier circuit de mesure $22_{B1}$ et dans le deuxième circuit de mesure $22_{B2}$ s'additionnent, de sorte que la résistance de mesure commune $R_{mes}$ est traversée par un courant $i_{mes}$, correspondant à la somme des courants $i_{mes1}$ et $i_{mes2}$.

Selon le premier mode de réalisation, la mesure du courant haché se fait en mesurant la tension $v_{mes}$ aux bornes de la résistance de mesure $R_{mes}$. En effet, cette tension $v_{mes}$ est une image du courant haché $i_e$, selon la formule (1) :

$$(1) \qquad v_{mes} = \frac{R_{mes}}{m_i} i_e$$

où $R_{mes}$ = résistance de mesure commune aux deux circuits de mesure $22_{B1}$ et $22_{B2}$, $v_{mes}$ = tension mesurée aux bornes de la résistance de mesure $R_{mes}$, $m_i$ = rapport de transformation d'un transformateur $10_{B1}$ ou $10_{B2}$.

On obtient ainsi une mesure directe aux bornes de la résistance de mesure $R_{mes}$ reliée à la masse.

Par contre, pendant les phases de démagnétisation d'un transformateur $10_{B1}$ ou $10_{B2}$, les transistors du circuit de mesure associé $22_{B1}$ ou $22_{B2}$ à l'état bloqué permettent de découpler la résistance de mesure $R_{mes}$ du circuit de démagnétisation $20_{B1}$ ou $20_{B2}$. Ainsi la mesure de la tension $V_{mes}$ n'est pas perturbée.

Dans un dispositif utile à la compréhension de l'invention et illustré sur la figure 3, les deux circuits de mesure $22_{B1}$ et $22_{B2}$ comportent chacun une résistance de mesure distincte $R_{mes}$'. Les deux résistances de mesure $R_{mes}$' sont de valeur sensiblement égale selon l'exemple décrit.

Dans ce dispositif, en ce qui concerne le premier circuit de mesure $22_{B1}$, la résistance de mesure $R_{mes}$' est connectée entre les deux sources du premier transistor $K_{i1\_HS}$, et du deuxième transistor $K_{i1\_LS}$. De plus, la source du deuxième transistor $K_{i1\_LS}$ est connectée à la masse.

En ce qui concerne le deuxième circuit de mesure $22_{B2}$, la résistance de mesure $R_{mes2}$ est connectée entre les deux sources du premier transistor $K_{i2\_HS}$, et du deuxième transistor $K_{i2\_LS}$. De plus, la source du deuxième transistor $K_{i2\_LS}$ est connectée à la masse.

Ainsi, les deux circuits de mesure $22_{B1}$ ; $22_{B2}$ comprennent respectivement une résistance de mesure $R_{mes}$' connectée par une borne à la masse. La résistance de mesure $R_{mes}$' du premier circuit de mesure $22_{B1}$ est connectée par une de ses bornes à la source du premier transistor $K_{i1\_HS}$, et par l'autre de ses bornes à la source du deuxième transistor $K_{i1\_LS}$ du premier circuit de mesure $22_{B1}$. La résistance de mesure $R_{mes}$' du deuxième circuit de mesure $22_{B2}$ est connectée à la source du premier transistor $K_{i2\_HS}$ par une de ses bornes, et par l'autre de ses bornes à la source du deuxième transistor $K_{i2\_LS}$ du deuxième circuit de mesure $22_{B2}$.

Qu'il s'agisse du premier mode de réalisation de la figure 2 ou du dispositif de la figure 3, la résistance de mesure commune $R_{mes}$ ou chaque résistance de mesure distincte $R_{mes}$' des deux circuits de mesure $22_{B1}$ et $22_{B2}$ est connectée à la masse. Cet agencement permet d'obtenir une meilleure immunité par rapport au bruit.

Dans le dispositif de la figure 3, le premier circuit de mesure $22_{B1}$ comprend une première résistance de sortie R connectée à la source du premier transistor $K_{i1\_HS}$ et à la résistance de mesure $R_{mes}$'.

De même, le deuxième circuit de mesure $22_{B2}$ comprend une deuxième résistance de sortie R connectée à la source du premier transistor $K_{i2\_HS}$ et à la résistance de mesure $R_{mes}$'. La tension $V_{mes}$ peut être mesurée au noeud commun entre les deux résistances de sortie R.

Dans ce cas, ce sont les tensions $v_{mes1}$ et $v_{mes2}$ respectivement aux bornes des résistances de mesure $R_{mes}$' des deux circuits de mesure $22_{B1}$ et $22_{B2}$ qui s'additionnent (cf. formule (2)) :

$$(2) \qquad v_{mes} = \frac{v_{mes1} + v_{mes2}}{2}$$

Dans le dispositif de la figure 3, la mesure du courant haché se fait en mesurant la tension $v_{mes}$ au noeud commun entre les deux résistances de sortie R. En effet, cette tension $v_{mes}$ est une image du courant haché $i_e$, selon la formule (3) :

$$(3) \qquad v_{mes} = \frac{1}{2} \frac{R_{mes}'}{m_i} i_e$$

où $R_{mes}'$ = résistance de mesure de chaque circuit de mesure $22_{B1}$ et $22_{B2}$,

$v_{mes}$ = tension mesurée au noeud commun entre les résistances de sortie R,

$m_i$ = rapport de transformation d'un transformateur $10_{B1}$ ou $10_{B2}$.

De façon similaire au premier mode de réalisation, ces résistances de mesure $R_{mes}'$ sont découplées du circuit de démagnétisation associé $20_{B1}$ ou $20_{B2}$ pendant la période de démagnétisation du transformateur associé $10_{B1}$ ou $10_{B2}$.

En outre, si la valeur de la résistance de mesure $R_{mes}'$ de chaque circuit de mesure $22_{B1}$ et $22_{B2}$ est sensiblement égale à la valeur de la résistance mesure $R_{mes}$ commune aux deux circuits de mesure $22_{B1}$ et $22_{B2}$, on constate un rapport de ½ dans la fonction de transfert.

Dans ce cas, si l'on souhaite travailler avec le même gain pour les deux modes de réalisation, il faut choisir la valeur de la résistance $R_{mes}'$ de chaque circuit $22_{B1}$ et $22_{B2}$ pour qu'elle soit de l'ordre du double de la valeur de la résistance de mesure commune $R_{mes}$ selon le premier mode de réalisation, (cf. formule (4)) :

$$(4) \; R_{mes}' = 2 \times R_{mes}$$

Le premier mode de réalisation avec la résistance de mesure commune $R_{mes}$ aux deux circuits de mesure $22_{B1}$ et $22_{B2}$ apporte une précision de mesure, car il y a moins de résistances.

Par ailleurs, le schéma de la figure 4 présente des précisions sur le circuit de mesure $22_{B1}$ ou $22_{B2}$ selon le premier mode de réalisation illustré sur la figure 2. Bien entendu, ces compléments ou précisions s'appliquent également au dispositif illustré sur la figure 3.

Sur le schéma de la figure 4, on constate que le premier circuit de mesure $22_{B1}$ comporte également une première résistance $R_{11}$ et une deuxième résistance $R_{21}$ connectées par une borne commune aux grilles des deux transistors $K_{i1\_HS}$ et $K_{i1\_LS}$ du circuit de mesure $22_{B1}$, et d'autre part à un troisième commutateur $K_{i1}$. Le troisième commutateur $K_{i1}$ du premier circuit de mesure $22_{B1}$ est commandé par le signal de commande $K_2$ qui commande aussi le deuxième commutateur $Mos_2$ de la première branche $B_1$.

De même, le deuxième circuit de mesure $22_{B2}$ comporte également une première résistance $R_{12}$ et une deuxième résistance $R_{22}$, connectées par un noeud commun aux grilles des deux transistors $K_{i2\_HS}$ et $K_{i2\_LS}$ du circuit de mesure $22_{B2}$, et d'autre part à un troisième commutateur $K_{i2}$. Le troisième commutateur $K_{i1}$ du deuxième circuit de mesure $22_{B2}$ est commandé par le signal de commande $K_4$ qui commande aussi le deuxième commutateur $Mos_4$ de la deuxième branche $B_2$.

La première résistance $R_{11}$ ou $R_{12}$ est connectée à un potentiel à titre d'exemple de 15V et la deuxième résistance $R_{21}$ ou $R_{22}$ est connectée à la masse.

Les première et deuxième résistances $R_{11}$ et $R_{21}$ ou $R_{12}$ et $R_{22}$ permettent de garantir la bonne commutation du premier transistor $K_{i1\_HS}$ ou $K_{i2\_HS}$ à l'état passant. Plus précisément, lorsque le troisième commutateur $K_{i1}$ ou $K_{i2}$ est bloqué, la tension $V_{G1}$, respectivement $V_{G2}$, aux grilles des transistors, est positive, par exemple de l'ordre de 10V. La valeur 10V permet d'obtenir la condition selon laquelle la tension entre la source et la grille d'un premier transistor $K_{i1\_HS}$ ou $K_{i2\_HS}$ est supérieure à la tension seuil du transistor.

Sinon, cette tension dépendante des valeurs des deux résistances $R_{11}$ et $R_{21}$, respectivement $R_{12}$ et $R_{22}$, est nulle.

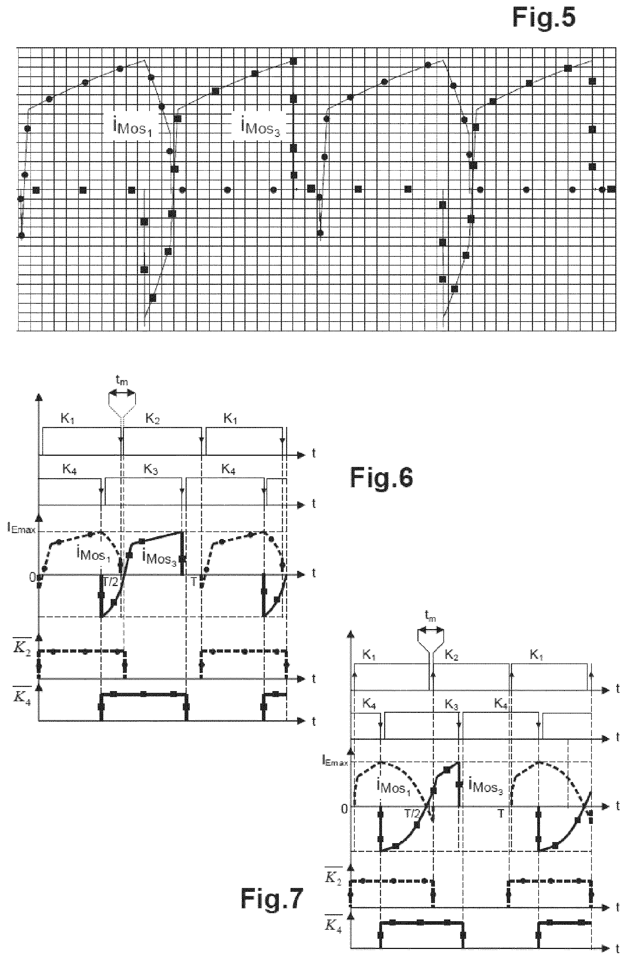

En référence aux figures 5 à 7, on décrit un exemple de logique de commande du dispositif 1 de mesure du courant haché selon l'un ou l'autre des modes de réalisation précédemment décrits.

**Fonctionnement du dispositif de mesure**

Évolution temporelle du courant haché

La figure 5 représente un exemple d'évolution temporelle des courants hachés $i_{Mos1}$ ou $i_{Mos3}$ circulant dans les circuits primaires 12 des transformateurs $10_{B1}$ et $10_{B2}$. L'exemple non limitatif illustré sur la figure 5 présente un rapport cyclique élevé.

Sur le graphe de la figure 5 :

- une première courbe avec des ronds, représente l'évolution temporelle du courant haché $i_{Mos1}$ dans le circuit primaire 12 du premier transformateur $10_{B1}$ connecté à la première branche $B_1$ du convertisseur 3, et

- une deuxième courbe avec des carrés, représente l'évolution temporelle du courant haché $i_{Mos3}$ dans le circuit primaire 12 du deuxième transformateur $10_{B2}$ connecté à la deuxième branche $B_2$ du convertisseur 3.

Le courant haché $i_{Mos1}$ ou $i_{Mos3}$ circulant dans le circuit primaire 12 d'un transformateur $10_{B1}$ ou $10_{B2}$ est périodique et est apte à prendre des valeurs nulles et des valeurs non nulles. Lorsque le circuit primaire 12 d'un transformateur $10_{B1}$ ou $10_{B2}$ est ouvert, le courant haché $i_{Mos1}$ ou $i_{Mos3}$ circulant dans le circuit primaire 12 du transformateur $10_{B1}$ ou $10_{B2}$ est nul, et on réalise la démagnétisation du transformateur $10_{B1}$ ou $10_{B2}$ correspondant.

Le décalage entre le courant haché $i_{Mos1}$ circulant dans le circuit primaire 12 du premier transformateur $10_{B1}$ et le courant haché $i_{Mos3}$ circulant dans le circuit primaire 12 du deuxième transformateur $10_{B2}$ dépend du décalage entre les branches $B_1$ et $B_2$.

Commande du premier circuit de mesure $22_{B1}$

Comme dit précédemment, le premier commutateur $Mos_1$ de la première branche $B_1$ est passant lorsque le deuxième commutateur $Mos_2$ de la première branche $B_1$ est bloqué, et réciproquement, le premier commutateur $Mos_1$ est bloqué lorsque le deuxième commutateur $Mos_2$ est passant. De plus, selon l'exemple de logique de commande illustré sur la figure 6 ou 7, un temps mort $t_m$ est prévu entre deux commutations.

Le premier transistor $K_{i1\_HS}$ et le deuxième transistor $K_{i1\_LS}$ du premier circuit de mesure $22_{B1}$ sont pilotés de façon commune.

Le premier transistor $K_{i1\_HS}$ et le deuxième transistor $K_{i1\_LS}$ du premier circuit de mesure $22_{B1}$ sont passants lorsque le deuxième commutateur $Mos_2$ de la première branche $B_1$ est bloqué.

Autrement dit, l'unité $K_{i1\_HS}$, $K_{i1\_LS}$ du premier circuit de mesure $22_{B1}$ configurée pour autoriser ou empêcher la circulation d'un courant induit par le courant haché $i_{Mos1}$ dans le premier circuit de mesure $22_{B1}$, est configurée pour être pilotée par l'inverse du signal de commande, nommé $\overline{K_2}$ du deuxième commutateur $Mos_2$ de la première branche $B_1$. C'est donc l'inverse du signal de commande du deuxième commutateur $Mos_2$, appelé $\overline{K_2}$, qui commande l'état des transistors $K_{i1\_HS}$ et $K_{i1\_LS}$ du premier circuit de commande $22_{B1}$ (cf figure 6 ou 7).

Ainsi, lorsque le deuxième commutateur $Mos_2$ de la première branche $B_1$ est bloqué, le circuit primaire 12 du premier transformateur $10_{B1}$ est fermé, le courant haché $i_{Mos1}$ circulant dans le circuit primaire 12 du premier transformateur $10_{B1}$ est non nul et induit un courant circulant dans le circuit secondaire 14 du premier transformateur $10_{B1}$. Les deux transistors $K_{i1\_HS}$ et $K_{i1\_LS}$ du premier circuit de mesure $22_{B1}$ sont passants, un courant $i_{mes1}$ peut librement circuler dans le circuit de mesure $22_{B1}$ associé au premier transformateur $10_{B1}$. Par contre, aucun courant ne circule dans le circuit de démagnétisation $20_{B1}$ parce que la deuxième diode Zener 26 n'est pas passante, étant donné que la tension entre les bornes 18 et 16 est variable et n'est pas égale à sa tension Zener.

Lorsque le deuxième commutateur $Mos_2$ de la première branche $B_1$ est passant et le premier commutateur $Mos_1$ est bloqué, le circuit primaire 12 du premier transformateur $10_{B1}$ est ouvert, le courant haché $i_{Mos1}$ prend une valeur nulle. Les deux transistors $K_{i1\_HS}$ et $K_{i1\_LS}$ du premier circuit de mesure $22_{B1}$ passent à l'état bloqué, ne permettant plus la circulation d'un courant dans le circuit de mesure $22_{B1}$.

Pendant cette période, un courant de démagnétisation circule dans le circuit de démagnétisation $20_{B1}$, la différence de potentiel entre les bornes 18 et 16 du circuit secondaire 14 étant alors imposée par la tension Zener de la deuxième diode Zener 26 selon l'exemple des figures 2 et 3. Les deux transistors $K_{i1\_HS}$ et $K_{i1\_LS}$ du premier circuit de mesure $22_{B1}$ à l'état bloqué, ne permettent pas la circulation du courant de démagnétisation dans le circuit de mesure $22_{B1}$.

Tant que le courant haché $i_{Mos1}$ est nul, le courant de démagnétisation décroît en circulant dans le circuit de démagnétisation $20_{B1}$.

Commande du deuxième circuit de mesure $22_{B2}$

De façon similaire, le premier commutateur $Mos_3$ de la deuxième branche $B_2$ est passant lorsque le deuxième commutateur $Mos_4$ de la deuxième branche $B_2$ est bloqué, et réciproquement, le premier commutateur $Mos_3$ est bloqué lorsque le deuxième commutateur $Mos_4$ est passant. Selon l'exemple de logique de commande illustré sur la figure 6 ou 7, un temps mort $t_m$ est également prévu entre deux commutations.

Le premier transistor $K_{i2\_HS}$ et le deuxième transistor $K_{i2\_LS}$ du deuxième circuit de mesure $22_{B2}$ sont pilotés de façon commune.

Le premier transistor $K_{i2\_HS}$ et le deuxième transistor $K_{i2\_LS}$ du deuxième circuit de mesure $22_{B2}$ sont passants lorsque le deuxième commutateur $Mos_4$ de la deuxième branche $B_2$ est bloqué.

L'unité $K_{i2\_HS}$, $K_{i2\_LS}$ du deuxième circuit de mesure $22_{B2}$ configurée pour autoriser ou empêcher la circulation d'un courant induit par le courant haché $i_{Mos3}$ dans le deuxième circuit de mesure $22_{B2}$ est configurée pour être pilotée par l'inverse du signal de commande $\overline{K_4}$ du deuxième commutateur $Mos_4$ de la deuxième branche $B_2$.

C'est donc l'inverse du signal de commande du deuxième commutateur $Mos_4$, appelé $\overline{K_4}$, qui commande l'état des transistors $K_{i2\_HS}$ et $K_{i2\_LS}$ du deuxième circuit de mesure $22_{B2}$ (cf. figure 6 ou 7).

Ainsi, lorsque le deuxième commutateur $Mos_4$ de la deuxième branche $B_2$ est bloqué, le circuit primaire 12 du deuxième transformateur $10_{B2}$ est fermé, le courant haché $i_{Mos3}$ circulant dans le circuit primaire 12 du deuxième transformateur $10_{B2}$ est non nul et induit un courant circulant dans le circuit secondaire 14 du deuxième transformateur $10_{B2}$. Les deux transistors $K_{i2\_HS}$ et $K_{i2\_LS}$ du deuxième circuit de mesure $22_{B2}$ sont passants, un courant $i_{mes2}$ peut librement circuler dans le circuit de mesure $22_{B2}$ associé au deuxième transformateur $10_{B2}$. Par contre, aucun courant ne circule dans le circuit de démagnétisation $20_{B2}$ parce que la deuxième diode Zener 26 n'est pas passante, étant donné que la tension entre les bornes 18 et 16 est variable et n'est pas égale à sa tension Zener.

Dès l'instant, où le deuxième commutateur $Mos_4$ de la deuxième branche $B_2$ est passant et le premier commutateur $Mos_3$ est bloqué, le circuit primaire 12 du deuxième transformateur $10_{B2}$ est ouvert, le courant haché $i_{Mos3}$ prend une valeur nulle. Les deux transistors $K_{i2\_HS}$ et $K_{i2\_LS}$ du deuxième circuit de mesure $22_{B2}$ passent à l'état bloqué, ne permettant plus la circulation d'un courant dans le circuit de mesure $22_{B2}$.

Cependant, pendant cette période, un courant de démagnétisation circule dans le circuit de démagnétisation $20_{B2}$, selon l'exemple illustré sur les figures 2 et 3, la différence de potentiel entre les bornes 18 et 16 du circuit secondaire 14 étant alors imposée par la tension Zener de la deuxième diode Zener 26. Tant que le courant haché $i_{Mos3}$ est nul, le courant magnétisant décroît en circulant dans le circuit de démagnétisation $20_{B2}$. Les deux transistors $K_{i2\_HS}$ et $K_{i2\_LS}$ du deuxième circuit de mesure $22_{B2}$ à l'état bloqué, ne permettent pas la circulation du courant de démagnétisation dans le circuit de mesure $22_{B2}$.

Ainsi sur une période T de fonctionnement, il y a toujours une demi période où le courant haché est nul, de sorte que le temps de démagnétisation est constant et permet de garantir la démagnétisation des transformateurs $10_{B1}$ et $10_{B2}$. La démagnétisation est donc indépendante du rapport cyclique.

Ainsi, quel que soit le sens du courant de démagnétisation, lorsque le circuit primaire 12 du transformateur $10_{B1}$ ou $10_{B2}$ est ouvert, le courant haché $i_{Mos1}$ ou $i_{Mos3}$ prend la valeur nulle, le dispositif 1 permet la démagnétisation du transformateur associé $10_{B1}$ ou $10_{B2}$. Autrement dit, étant donné que le sens du courant de démagnétisation dépend de la valeur moyenne du courant haché $i_{Mos1}$ ou $i_{Mos3}$, quelle que soit la valeur moyenne du courant haché $i_{Mos1}$ ou $i_{Mos3}$, le dispositif 1 permet la démagnétisation du transformateur associé $10_{B1}$ ou $10_{B2}$.

En ce qui concerne la mesure du courant haché, ceci s'effectue en mesurant la tension $v_{mes}$ aux bornes de la résistance de mesure $R_{mes}$ selon le premier mode de réalisation illustré sur la figure 2 ou 4, ou en mesurant la tension $v_{mes}$ au noeud commun entre les résistances de sortie R des deux circuits de mesure $22_{B1}$ et $22_{B2}$ dans le dispositif illustré sur la figure 3, la tension $v_{mes}$ étant proportionnelle au courant haché $i_e$, selon la formule (1) pour le premier mode de réalisation ou selon la formule (3) pour le dispositif illustré sur la figure 3.

En référence à la figure 8, cette mesure de la tension $v_{mes}$ par exemple mesurée aux bornes de la résistance de mesure $R_{mes}$, permet d'avoir une information sur la valeur moyenne du courant d'entrée $i_e$ absorbé par le convertisseur 3, par exemple par l'intermédiaire d'un double filtre RC permettant d'obtenir la tension $V_{IE}$ correspondant à la valeur moyenne de la tension $V_{mes}$.

En outre, on peut souhaiter contrôler la valeur pic du courant instantané $i_e$. On peut prévoir à cet effet, deux comparateurs. Le premier comparateur étant par exemple prévu pour la limitation du courant, et le deuxième comparateur pour la détection de défaut.

## Revendications

1. Dispositif (1) de mesure d'un courant haché ($i_e$) apte à circuler dans un circuit (3) présentant une structure de pont en H comprenant une première branche ($B_1$) et une deuxième branche ($B_2$), **caractérisé en ce qu'**il comporte :

   - deux transformateurs ($10_{B1}$ ; $10_{B2}$) respectivement connectés à une branche ($B_1$, $B_2$) du pont en H, les transformateurs ($10_{B1}$ ; $10_{B2}$) comportant respectivement un circuit primaire (12) configuré pour la circulation d'un courant haché ($i_{Mos1}$ ; $i_{Mos3}$), et un circuit secondaire (14),
   - deux circuits ($20_{B1}$ ; $20_{B2}$) de démagnétisation des deux transformateurs ($10_{B1}$ ; $10_{B2}$), et
   - deux circuits de mesure ($22_{B1}$ ; $22_{B2}$) respectivement connectés aux bornes (16, 18) du circuit secondaire (14) d'un transformateur ($10_{B1}$ ; $10_{B2}$) associé, les circuits de mesure ($22_{B1}$ ; $22_{B2}$) comprenant respectivement au moins une unité qui comporte un premier commutateur ($K_{i1\_HS}$ ; $K_{i2\_HS}$) et un deuxième commutateur ($K_{i1\_LS}$ ; $K_{i2\_LS}$) connectés en inverse, les deux commutateurs ($K_{i1\_HS}$, $K_{i1\_LS}$; $K_{i2\_HS}$, $K_{i2\_LS}$) étant respectivement réalisés par un transistor et étant aptes à être pilotés de façon :

      - à autoriser la circulation du courant ($i_{mes1}$ ; $i_{mes2}$) induit par le courant haché ($i_{Mos1}$ ; $i_{Mos3}$), dans le circuit de mesure ($22_{B1}$ ; $22_{B2}$) lorsque le circuit primaire (12) d'un transformateur ($10_{B1}$ ; $10_{B2}$) associé est fermé et
      - à empêcher la circulation du courant de démagnétisation dans le circuit de mesure ($22_{B1}$ ; $22_{B2}$) lorsque le circuit primaire (12) d'un transformateur ($10_{B1}$ ; $10_{B2}$) associé est ouvert ;

   les circuits de mesure ($22_{B1}$ ; $22_{B2}$) comprenant une résistance de mesure ($R_{mes}$) commune connectée par une première borne à la masse, et par une deuxième borne à la source du premier transistor ($K_{i1\_HS}$) du premier circuit de mesure ($22_{B1}$) et à la source du premier transistor ($K_{i2\_HS}$) du deuxième circuit de mesure ($22_{B2}$).

2. Dispositif de mesure selon la revendication 1, dans lequel le premier commutateur ($K_{i1\_HS}$ ; $K_{i2\_HS}$) et le deuxième commutateur ($K_{i1\_LS}$ ; $K_{i2\_LS}$) sont respectivement réalisés par un transistor à effet de champ.

**3.** Dispositif selon la revendication 1 ou 2, dans lequel :

- le premier commutateur ($K_{i1\_HS}$ ; $K_{i2\_HS}$) d'un circuit de mesure ($22_{B1}$ ; $22_{B2}$) comporte une borne connectée à une deuxième borne de la résistance de mesure ($R_{mes}$ ; $R_{mes}$'), la première borne de la résistance de mesure ($R_{mes}$ ; $R_{mes}$') étant connectée à la masse ; et
- le deuxième commutateur ($K_{i1\_LS}$ ; $K_{i2\_LS}$) d'un circuit de mesure ($22_{B1}$ ; $22_{B2}$) comporte une borne connectée à la masse.

**4.** Dispositif selon l'une quelconque des revendications précédentes, dans lequel :

- les branches ($B_1$, $B_2$) du circuit (3) comprennent respectivement un premier commutateur ($Mos_1$, $Mos_3$) et un deuxième commutateur ($Mos_2$, $Mos_4$),
- le premier transformateur ($10_{B1}$) est connecté au premier commutateur ($Mos_1$) de la première branche ($B_1$) et le deuxième transformateur ($10_{B2}$) est connecté au premier commutateur ($Mos_3$) de la deuxième branche ($B_2$), et
- l'unité ($K_{i1\_HS}$, $K_{i1\_LS}$) du premier circuit de mesure ($22_{B1}$) configurée pour autoriser ou empêcher la circulation d'un courant induit par le courant haché ($i_{Mos1}$) dans le premier circuit de mesure ($22_{B1}$) est configurée pour être pilotée par l'inverse du signal de commande du deuxième commutateur ($\overline{K_2}$) de la première branche ($B_1$) et
- l'unité ($K_{i2\_HS}$, $K_{i2\_L}$S) du deuxième circuit de mesure ($22_{B2}$) configurée pour autoriser ou empêcher la circulation d'un courant induit par le courant haché ($i_{Mos3}$) dans le deuxième circuit de mesure ($22_{B2}$) est configurée pour être pilotée par l'inverse du signal de commande du deuxième commutateur ($\overline{K_4}$) de la deuxième branche ($B_2$).

**5.** Dispositif selon l'une quelconque des revendications précédentes, dans lequel :

- le premier circuit de mesure ($22_{B1}$) comporte une première résistance ($R_{11}$) et une deuxième résistance ($R_{21}$), la borne commune aux deux résistances ($R_{11}$, $R_{21}$) étant connectée à la grille du premier transistor ($K_{i1\_HS}$) et du deuxième transistor ($K_{i1\_LS}$) du premier circuit de mesure ($22_{B1}$), et
- le deuxième circuit de mesure ($22_{B2}$) comporte une première résistance ($R_{12}$) et une deuxième résistance ($R_{22}$), la borne commune aux deux résistances ($R_{12}$, $R_{22}$) étant connectée à la grille du premier transistor ($K_{i2\_HS}$) et du deuxième transistor ($K_{i2\_LS}$) du deuxième circuit de mesure ($22_{B2}$).

**6.** Dispositif selon l'une quelconque des revendications précédentes, dans lequel un circuit de démagnétisation ($20_{B1}$ ; $20_{B2}$) est connecté entre les deux bornes de sortie (16,18) du circuit secondaire (14) du transformateur ($10_{B1}$ ; $10_{B2}$) associé.

**7.** Dispositif selon la revendication précédente, dans lequel un circuit de démagnétisation ($20_{B1}$ ; $20_{B2}$) comporte deux diodes Zener (24, 26) montées en série et en sens inverse.

**Patentansprüche**

**1.** Vorrichtung (1) zum Messen eines zerhackten Stroms ($i_e$), der in einer Schaltung (3) fließen kann, die einen H-Brücke-Aufbau aufweist, der einen ersten Zweig ($B_1$) und einen zweiten Zweig ($B_2$) enthält, **dadurch gekennzeichnet, dass** sie aufweist:

- zwei Transformatoren ($10_{B1}$; $10_{B2}$), die je mit einem Zweig ($B_1$, $B_2$) der H-Brücke verbunden sind, wobei die Transformatoren ($10_{B1}$; $10_{B2}$) eine Primärschaltung (12), die für das Fließen eines zerhackten Stroms ($i_{Mos1}$; $i_{Mos3}$) konfiguriert ist, bzw. eine Sekundärschaltung (14) aufweisen,
- zwei Schaltungen ($20_{B1}$; $20_{B2}$) zur Entmagnetisierung der zwei Transformatoren ($10_{B1}$; $10_{B2}$), und
- zwei Messschaltungen ($22_{B1}$; $22_{B2}$), die je mit den Klemmen (16, 18) der Sekundärschaltung (14) eines zugeordneten Transformators ($10_{B1}$; $10_{B2}$) verbunden sind, wobei die Messschaltungen ($22_{B1}$; $22_{B2}$) je mindestens eine Einheit enthalten, die einen ersten Schalter ($K_{i1\_HS}$; $k_{i2\_HS}$) und einen zweiten Schalter ($K_{i1\_LS}$; $K_{i2\_LS}$) aufweist, die invers verbunden sind, wobei die zwei Schalter ($K_{i1\_HS}$, $K_{i1\_LS}$; $K_{i2\_HS}$, $K_{i2\_LS}$) je von einem Transistor realisiert werden und so gesteuert werden können, dass sie:

- das Fließen des vom zerhackten Strom ($i_{Mos1}$; $i_{Mos3}$) induzierten Stroms ($i_{mes1}$; $i_{mes2}$) in der Messschaltung ($22_{B1}$; $22_{B2}$) erlauben, wenn die Primärschaltung (12) eines zugeordneten Transformators ($10_{B1}$; $10_{B2}$) geschlossen ist, und
- das Fließen des Entmagnetisierungsstroms in der Messschaltung ($22_{B1}$; $22_{B2}$) verhindern, wenn die Primärschaltung (12) eines zugeordneten Transformators ($10_{B1}$; $10_{B2}$) offen ist;

wobei die Messschaltungen ($22_{B1}$; $22_{B2}$) einen gemeinsamen Messwiderstand ($R_{mes}$) enthalten, der

durch eine erste Klemme mit Masse und durch eine zweite Klemme mit der Source des ersten Transistors ($K_{i1\_HS}$) der ersten Messschaltung ($22_{B1}$) und mit der Source des ersten Transistors ($K_{i2\_HS}$) der zweiten Messschaltung ($22_{B2}$) verbunden ist.

2. Messvorrichtung nach Anspruch 1, wobei der erste Schalter ($K_{i1\_HS}$; $K_{i2\_HS}$) und der zweite Schalter ($K_{i1\_LS}$; $K_{i2\_LS}$) je durch einen Feldeffekt-Transistor realisiert werden.

3. Vorrichtung nach Anspruch 1 oder 2, wobei:

   - der erste Schalter ($K_{i1\_HS}$; $K_{i2\_HS}$) einer Messschaltung ($22_{B1}$; $22_{B2}$) eine mit einer zweiten Klemme des Messwiderstands ($R_{mes}$; $R_{mes}$') verbundene Klemme aufweist, wobei die erste Klemme des Messwiderstands ($R_{mes}$; $R_{mes}$') mit Masse verbunden ist; und
   - der zweite Schalter ($K_{i1\_LS}$; $K_{i2\_LS}$) einer Messschaltung ($22_{B1}$; $22_{B2}$) eine mit Masse verbundene Klemme aufweist.

4. Vorrichtung nach einem der vorhergehenden Ansprüche, wobei:

   - die Zweige ($B_1$, $B_2$) der Schaltung (3) je einen ersten Schalter ($Mos_1$, $Mos_3$) und einen zweiten Schalter ($Mos_2$, $Mos_4$) enthalten,
   - der erste Transformator ($10_{B1}$) mit dem ersten Schalter ($Mos_1$) des ersten Zweigs ($B_1$) und der zweite Transformator ($10_{B2}$) mit dem ersten Schalter ($Mos_3$) des zweiten Zweigs ($B_2$) verbunden ist, und
   - die Einheit ($K_{i1\_HS}$, $K_{i1\_LS}$) der ersten Messschaltung ($22_{B1}$), die konfiguriert ist, das Fließen eines durch den zerhackten Strom ($i_{Mos1}$) induzierten Stroms in der ersten Messschaltung ($22_{B1}$) zu erlauben oder zu verhindern, konfiguriert ist, vom Kehrwert des Steuersignals des zweiten Schalters ($\overline{K_2}$) des ersten Zweigs ($B_1$) gesteuert zu werden, und
   - die Einheit ($K_{i2\_HS}$, $K_{i2\_LS}$) der zweiten Messschaltung ($22_{B2}$), die konfiguriert ist, das Fließen eines vom zerhackten Strom ($i_{Mos3}$) induzierten Stroms in der zweiten Messschaltung ($22_{B2}$) zu erlauben oder zu verhindern, konfiguriert ist, vom Kehrwert des Steuersignals des zweiten Schalters ($\overline{K_4}$) des zweiten Zweigs ($B_2$) gesteuert zu werden.

5. Vorrichtung nach einem der vorhergehenden Ansprüche, wobei:

   - die erste Messschaltung ($22_{B1}$) einen ersten Widerstand ($R_{11}$) und einen zweiten Widerstand ($R_{21}$) aufweist, wobei die den zwei Widerständen ($R_{11}$, $R_{21}$) gemeinsame Klemme mit dem Gate des ersten Transistors ($K_{i1\_HS}$) und des zweiten Transistors ($K_{i1\_LS}$) der ersten Messschaltung ($22_{B1}$) verbunden ist, und
   - die zweite Messschaltung ($22_{B2}$) einen ersten Widerstand ($R_{12}$) und einen zweiten Widerstand ($R_{22}$) aufweist, wobei die den zwei Widerständen ($R_{12}$, $R_{22}$) gemeinsame Klemme mit dem Gate des ersten Transistors ($K_{i2\_HS}$) und des zweiten Transistors ($K_{i2\_LS}$) der zweiten Messschaltung ($22_{B2}$) verbunden ist.

6. Vorrichtung nach einem der vorhergehenden Ansprüche, wobei eine Entmagnetisierungsschaltung ($20_{B1}$; $20_{B2}$) zwischen den zwei Ausgangsklemmen (16, 18) der Sekundärschaltung (14) des zugeordneten Transformators ($10_{B1}$; $10_{B2}$) verbunden ist.

7. Vorrichtung nach dem vorhergehenden Anspruch, wobei eine Entmagnetisierungsschaltung ($20_{B1}$; $20_{B2}$) zwei Zener-Dioden (24, 26) aufweist, die in Reihe und in Gegenrichtung geschaltet sind.

**Claims**

1. Device (1) for measuring a chopped current ($i_e$) capable of flowing in a circuit (3) having an H-bridge structure including a first branch ($B_1$) and a second branch ($B_2$), **characterized in that** it comprises:

   - two transformers ($10_{B1}$; $10_{B2}$) respectively connected to a branch ($B_1$, $B_2$) of the H-bridge, the transformers ($10_{B1}$; $10_{B2}$) respectively comprising a primary circuit (12) configured for the flow of a chopped current ($i_{Mos1}$; $i_{Mos3}$), and a secondary circuit (14),
   - two circuits ($20_{B1}$; $20_{B2}$) for demagnetizing the two transformers ($10_{B1}$; $10_{B2}$), and
   - two measuring circuits ($22_{B1}$; $22_{B2}$) respectively connected to the terminals (16, 18) of the secondary circuit (14) of an associated transformer ($10_{B1}$; $10_{B2}$), the measuring circuits ($22_{B1}$; $22_{B2}$) respectively including at least one unit which comprises a first switch ($K_{i1\_HS}$; $K_{i2\_HS}$) and a second switch ($K_{i1\_LS}$; $K_{i2\_LS}$) connected in reverse, the two switches ($K_{i1\_HS}$, $K_{i1\_LS}$; $K_{i2\_HS}$, $K_{i2\_LS}$) being respectively implemented by a transistor and being capable of being controlled so as to:

     - allow the flow of the current ($i_{mes1}$; $i_{mes2}$) induced by the chopped current ($i_{Mos1}$; $i_{Mos3}$), in the measuring circuit ($22_{B1}$; $22_{B2}$) when the primary circuit (12) of an associated transformer ($10_{B1}$; $10_{B2}$) is closed, and

- prevent the flow of the demagnetizing current in the measuring circuit ($22_{B1}$; $22_{B2}$) when the primary circuit (12) of an associated transformer ($10_{B1}$; $10_{B2}$) is open;

the measuring circuits ($22_{B1}$; $22_{B2}$) including a common measuring resistor ($R_{mes}$) connected via a first terminal to earth, and via a second terminal to the source of the first transistor ($K_{i1\_HS}$) of the first measuring circuit ($22_{B1}$) and to the source of the first transistor ($K_{i2\_HS}$) of the second measuring circuit ($22_{B2}$).

2. Measuring device according to Claim 1, in which the first switch ($K_{i1\_HS}$; $K_{i2\_HS}$) and the second switch ($K_{i1\_LS}$; $K_{i2\_LS}$) are respectively implemented by a field effect transistor.

3. Device according to Claim 1 or 2, in which:

   - the first switch ($K_{i1\_HS}$; $K_{i2\_HS}$) of a measuring circuit ($22_{B1}$; $22_{B2}$) comprises a terminal connected to a second terminal of the measuring resistor (rimes; Rues'), the first terminal of the measuring resistor ($R_{mes}$; $R_{mes}$') being connected to earth; and
   - the second switch ($K_{i1\_LS}$; $K_{i2\_LS}$) of a measuring circuit ($22_{B1}$; $22_{B2}$) comprises a terminal connected to earth.

4. Device according to any one of the preceding claims, in which:

   - the branches ($B_1$, $B_2$) of the circuit (3) respectively include a first switch ($Mos_1$, $Mos_3$) and a second switch ($Mos_2$, $Mos_4$),
   - the first transformer ($10_{B1}$) is connected to the first switch ($Mos_1$) of the first branch ($B_1$) and the second transformer ($10_{B2}$) is connected to the first switch ($Mos_3$) of the second branch ($B_2$), and
   - the unit ($K_{i1\_HS}$, $K_{i1\_LS}$) of the first measuring circuit ($22_{B1}$) configured for allowing or preventing the flow of a current induced by the chopped current ($i_{Mos1}$) in the first measuring circuit ($22_{B1}$), is configured for being controlled by the inverse of the control signal of the second switch ($\overline{K_2}$) of the first branch ($B_1$) and
   - the unit ($K_{i2\_HS}$, $K_{i2-LS}$) of the second measuring circuit ($22_{B2}$) configured for allowing or preventing the flow of a current induced by the chopped current ($i_{Mos3}$) in the second measuring circuit ($22_{B2}$) is configured for being controlled by the inverse of the control signal of the second switch ($\overline{K_4}$) of the second branch ($B_2$).

5. Device according to any one of the preceding claims, in which:

   - the first measuring circuit ($22_{B1}$) comprises a first resistor ($R_{11}$) and a second resistor ($R_{21}$), the terminal common to the two resistors ($R_{11}$, $R_{21}$) being connected to the gate of the first transistor ($K_{i1\_HS}$) and of the second transistor ($K_{i1\_LS}$) of the first measuring circuit ($22_{B1}$), and
   - the second measuring circuit ($22_{B2}$) comprises a first resistor ($R_{12}$) and a second resistor ($R_{22}$), the terminal common to the two resistors ($R_{12}$, $R_{22}$) being connected to the gate of the first transistor ($K_{i2\_HS}$) and of the second transistor ($K_{i2\_LS}$) of the second measuring circuit ($22_{B2}$).

6. Device according to any one of the preceding claims, in which a demagnetizing circuit ($20_{B1}$; $20_{B2}$) is connected between the two output terminals (16,18) of the secondary circuit (14) of the associated transformer ($10_{B1}$; $10_{B2}$).

7. Device according to the preceding claim, in which a demagnetizing circuit ($20_{B1}$; $20_{B2}$) comprises two Zener diodes (24, 26) mounted in series and in opposite directions.

Fig.1

Fig.2

**Fig.3**

**Fig.8**

# Fig.4

Fig.5

Fig.6

Fig.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012127769 A1
- WO 03028198 A1